# EUROPÄISCHE PATENTSCHRIFT

(11) **EP 2 792 642 B1**
(45) Veröffentlichungstag und Bekanntmachung des Hinweises auf die Patenterteilung: **21.02.2018**
(21) Anmeldenummer: 13163776.1
(22) Anmeldetag: 15.04.2013
(51) Int. Cl.: C01G 55/00, C01G 3/02, C01G 5/00, C09C 3/08, H01L 23/00, B23K 35/02, B23K 35/36, H05K 1/11

(54) **Sinterpaste mit gecoateten Silberoxid auf schwer sinterbare edlen und unedlen Oberflächen**
Sinter paste with coated silver oxide on noble and non-noble surfaces that are difficult to sinter
Pâte de brasure avec oxyde d'argent revêtu sur des surfaces nobles et communes difficiles à braser

(43) Veröffentlichungstag der Anmeldung: 22.10.2014
(73) Patentinhaber: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE); Duch, Susanne Klaudia, 63486 Bruchköbel (DE)
(74) Vertreter: Heraeus IP

(56) Entgegenhaltungen:
- WO-A1-2012/052191
- DE-A1-102010 042 702
- US-A1- 2008 156 398
- US-A1- 2010 270 515

## Beschreibung

Die vorliegende Erfindung betrifft eine Paste, die mit einer organischen Verbindung beschichtete Silberoxidpartikel enthält, und ein Verfahren zum Verbinden von Bauelementen, bei dem diese Paste eingesetzt wird. Weiterhin betrifft die vorliegende Erfindung ein Modul, das unter Verwendung der Paste hergestellt wird sowie ein Verfahren zur Herstellung der beschriebenen Paste.

Im Bereich der Leistungselektronik stellt das Verbinden von Bauelementen, wie LEDs oder sehr dünnen Siliziumchips, die eine hohe Druck- und Temperaturempfindlichkeit aufweisen, eine besondere Herausforderung dar. Aus diesem Grund werden solche druck- und temperaturempfindlichen Bauelemente häufig durch Kleben miteinander verbunden. Die Klebetechnik weist allerdings den Nachteil auf, dass damit Kontaktstellen zwischen den Bauelementen geschaffen werden, die nur eine unzureichende Wärmeleitfähigkeit bzw. elektrische Leitfähigkeit aufweisen. Um dieses Problem zu lösen, werden die zu verbindenden Bauelemente häufig gesintert. Die Sintertechnik stellt ein sehr einfaches Verfahren zum stabilen Verbinden von Bauelementen dar, wobei das Verbinden unter Verwendung von Sinterpasten erfolgt.

US-B-7,766,218 beschreibt die Verwendung von Sinterpasten, welche zumindest teilweise mit Fettsäuren oder Fettsäurederivaten beschichtete Silberpartikel sowie ein flüchtiges Dispersionsmittel enthalten, um die Sinterung sowie die elektrische und thermische Leitfähigkeit zu verbessern.

WO-A-2011/026624 offenbart Sinterpasten, welche Metallpartikel, Metallprecursor, Lösungsmittel und Sinterhilfsmittel enthalten.

Gemäß der EP-A-2425920 wird den Sinterpasten wenigstens eine aliphatische Kohlenwasserstoffverbindung zugegeben, um eine niedrige Sintertemperatur zu gewährleisten.

US2008/01563398A1 offenbart eine Sinterpaste beinhaltend Metalloxide der Elemente Gold, Kupfer oder Silber mit einem Partikeldurchmesser von 1 nm bis 50 µm und einem Gewichtsanteil von 50 bis 99 Gew.-%, bezogen auf die Gesamtmasse der Sinterpaste. Weiterhin beinhaltet die Sinterpaste Reduktionsmittel (z.B. Fettsäuren), metallische Silberpartikel, Dispersionsmittel und organische Polymere.

Sowohl DE102010042702A1 als auch WO2012/052191A1 offenbaren Ausgangswerkstoffe einer Sinterverbindung bestehend aus Partikeln eines Edelmetalloxides (z.B. Silberoxid) und einer ein Reduzierungsmittel aufweisenden Beschichtung (z.B. Fettsäuren). Weiterhin kann der Ausgangswerkstoff Edelmetallpartikel (Silber) enthalten. Die Partikeldurchmesser liegen zwischen 0,01 und 50 µm.

US2010/270515A1 offenbart eine Sinterpaste beinhaltend Partikel bestehend aus metallischem Silber und Silberoxid. Weiterhin wird ein reduzierendes organisches Material als Dispersionsmittel verwendet (z.B. Fettsäuren). Die organischen Komponenten sind an der Partikeloberfläche angelagert. Die Partikeldurchmesser betragen weniger als 100 µm.

In der Praxis hat sich jedoch gezeigt, dass trotz der Verwendung verschiedener Sinterhilfsmittel die Sinterfähigkeit herkömmlicher Pasten oder Mischungen, insbesondere bei geringen Prozessdrücken, unzureichend ist.

Der vorliegenden Erfindung liegt daher die Aufgabe zugrunde, eine Mischung, insbesondere eine Sinterpaste, bereitzustellen, welche es erlaubt auch schwer sinterbare Oberflächen, die beispielsweise einen hohen Grad an Verunreinigungen aufweisen, stabil und guthaftend miteinander zu verbinden.

Die Aufgabe wird erfindungsgemäß durch das Bereitstellen einer Paste gelöst, die
a) Silberoxidpartikel und Silberpartikel, wobei das Gewichtsverhältnis von Silberpartikel zu Silberoxidpartikel höchstens 6 zu 1 ist und
b) eine organische Verbindung, die durch die Formel I dargestellt ist:

   R¹-COR² (I),

   wobei R¹ ein aliphatischer Rest mit 8 bis 32 Kohlenstoffatomen ist und R² entweder-OM ist oder die Struktur-X-R³ aufweist, wobei X ausgewählt ist aus der Gruppe bestehend aus O, S, N-R⁴, wobei R⁴ ein Wasserstoffatom oder ein aliphatischer Rest, R³ ein Wasserstoffatom oder ein aliphatischer Rest und M ein Kation ist, und
c) ein Dispergiermittel enthält,
dadurch gekennzeichnet, dass die Paste, bezogen auf ihr Gesamtgewicht, 0,05 bis 2,0 Gew.-% eines Sauerstoff enthaltenden Polymers enthält, welches ausgewählt ist aus der Gruppe bestehend aus Methylcellulose, Ethylcellulose, Ethylmethylcellulose, Carboxycellulose, Hydroxypropylcellulose, Hydroxyethylcellulose, Hydroxymethylcellulose oder Mischungen hiervon.

Ein häufig auftretendes Problem beim Verbinden metallischer Oberflächen mittels Sintern ist eine mangelnde Anbindung des gesinterten Sintermaterials an die Oberfläche. So kommt es beispielsweise bei Oberflächen, die mit Verunreinigungen bedeckt sind oder bei Aluminiumoberflächen, die galvanisch versilbert wurden, nicht zu der gewünschten Anbindung des Sintermaterials an die Oberfläche, wodurch die Stabilität beispielsweise eines Moduls, das aus mehreren Bauelementen, die mit Hilfe von Sinterpasten verbunden sind, nicht mehr in ausreichender Form gegeben ist. Neben der Stabilität wirkt sich die schlechte Verbindung der Bauelemente sowohl auf ihre elektrische als auch auf ihre Wärmeleitfähigkeit negativ aus.

Es wurde überraschend gefunden, dass die erfindungsgemäßen Pasten eine hervorragende Anbindung an Oberflächen aufweisen, die mit den im Stand der Technik offenbarten Mischungen üblicherweise nicht in ausreichendendem Maß versintert, insbesondere unter den gewünschten niedrigen Temperaturen nicht hinreichend versintert werden konnten. Dazu zählen, wie bereits erwähnt, beispielsweise Oberflächen, die mit kohlenstoffhaltigen Verbindungen bedeckt sind, also beispielsweise eine Schutzschicht aus einem organischen Polymer aufweisen.

Weiterhin ist eine Ausführungsform der vorliegenden Erfindung bevorzugt, bei der die Silberoxidpartikel ganz oder teilweise mit der organischen Verbindung b) beschichtet sind.

Unter einer Beschichtung der Partikel wird erfindungsgemäß eine festhaftende Schicht auf der Oberfläche der Partikel verstanden. Unter einer festhaftenden Schicht versteht man, dass sich die Schicht nicht bereits gravitationsbedingt von den Partikeln löst.

Die Paste enthält Silberoxidpartikel. Bei den Silberoxidpartikeln im Rahmen der vorliegenden Erfindung beschränkt sich die Anwesenheit des Sauerstoffs nicht nur auf die Oberfläche des Silbers, es handelt sich also nicht um Silber, das mit einer Oxidschicht bedeckt ist. Vielmehr liegt bevorzugt eine homogene Verteilung des Sauerstoffs in der Verbindung vor. Dabei beträgt das molare Verhältnis von Sauerstoff zu Silber mindestens 1:2.

Die erfindungsgemäße Paste enthält Silberpartikel.

In einer bevorzugten Ausführungsform sind die Silberpartikel ebenfalls ganz oder teilweise mit der organischen Verbindung b) beschichtet.

Die erfindungsgemäße Paste enthält Silberoxidpartikel und Silberpartikel, wobei das Gewichtsverhältnis von Silberpartikel zu Silberoxidpartikel höchstens 6:1, bevorzugt höchstens 4:1 oder vorzugsweise höchstens 3:2, weiter bevorzugt höchstens 1:1 und insbesondere höchstens 2:3, speziell höchstens 1:2 ist und wobei die Silberoxidpartikel und die Silberpartikel, falls vorhanden, mit der organischen Verbindung b) bevorzugt beschichtet sind.

Bevorzugt ist das Gewichtsverhältnis von Silberpartikel zu Silberoxidpartikel in einem Bereich von 4:1 bis 1:10, bevorzugt von 2:1 bis 1:4, speziell bevorzugt von 2:1 bis 1:2 oder vorzugsweise von 3:2 bis 1:9, weiter bevorzugt 4:3 bis 1:4.

Besonders bevorzugt ist eine Ausführungsform, in der das Gewichtsverhältnis von Silberpartikeln zu Silberoxidpartikeln höchstens 3:2 beträgt.

In einer bevorzugten Ausführungsform ist der Anteil der Silberpartikel an der Paste kleiner als 30 Gew.-%, vorzugsweise kleiner als 10 Gew.-%, besonders bevorzugt kleiner als 2 Gew.-%, speziell zwischen 0,01 Gew.-% und 2,0 Gew.-%, jeweils bezogen auf das Gesamtgewicht der Paste.

Das Verhältnis von Silberoxidpartikeln, insbesondere mit einer organischen Verbindung b) beschichteten Silberoxidpartikeln, zu Silberpartikeln, insbesondere mit der Verbindung b) beschichteten Silberpartikeln, ist vorzugsweise so gewählt, dass die Sintereigenschaften der Paste den individuellen Anforderungen des jeweiligen Prozesses angepasst sind. Dabei ist das Verhältnis abhängig von der Art des Sinterprozesses. Es wurde überraschend gefunden, dass sich ein möglichst hoher Gehalt an, insbesondere mit einer organischen Verbindung b) beschichteten, Silberoxidpartikeln vorteilhaft bei Sinterprozessen auswirkt, die unter erhöhtem Druck erfolgen. Bei Sintervorgängen unter Normaldruck hat sich dagegen gezeigt, dass sich durch die Beimischung von, insbesondere mit der organischen Verbindung b) beschichteten, Silberpartikeln zu den beschichteten Silberoxidpartikeln ein positiver Bindungseffekt erzielen lässt.

Die Größe der Partikel in einer Paste hat einen Einfluss auf die Eigenschaften der Paste, wie etwa ihre Verarbeitbarkeit oder ihre Sinterfähigkeit. Unter Größe des Partikels ist erfindungsgemäß der durchschnittliche volumenbezogene Durchmesser des Partikels zu verstehen.

In einer erfindungsgemäßen Ausführungsform der vorliegenden Erfindung liegt die durchschnittliche Primärpartikelgröße der mit der organischen Verbindung b) beschichteten Silberoxidpartikel zwischen 0,1 bis 3,0 µm, vorzugsweise zwischen 0,3 bis 2,5 µm. Unter durchschnittlicher Primärpartikelgröße im Sinne der Erfindung ist die längste Ausdehnung eines Partikels zu verstehen, das heißt die Entfernung zwischen den beiden am weitetesten voneinander entfernt liegenden Enden des Partikels. Zur Bestimmung der durchschnittlichen Primärpartikelgröße wurden rasterelektronenmikroskopische Aufnahmen der erfindungsgemäßen Silberoxidpartikel bei einer Auflösung von 1:1000 gemacht und die Partikel vermessen. Der durchschnittliche Wert wurde aus 100 Messpunkten errechnet. Weiterhin bevorzugt liegen die mit der organischen Verbindung b) beschichteten Silberoxidpartikel in sphärischer Form vor. Es ist dem Fachmann jedoch klar, dass von den eingesetzten Partikeln herstellungsbedingt auch ein untergeordneter Anteil eine nicht-sphärische Form aufweisen kann.

Obwohl die beschichteten Silberoxidpartikel eine deutlich geringere Tendenz zur Agglomerierung zeigen, kann es aufgrund der Zusammensetzung der Paste und der Natur der mit der organischen Verbindung b) beschichteten Silberoxidpartikel zu Agglomerationen der Partikel kommen, bei denen sich mehrere Partikel zu einem größeren Verbund zusammenlagern. Vorzugsweise weisen diese Agglomerate eine durchschnittliche Größe bis maximal 50 µm auf. Unter durchschnittlicher Größe im Sinne der vorliegenden Erfindung ist die maximale Ausdehnung eines Agglomerates zu verstehen, also die Entfernung zwischen den beiden am weitesten auseinander liegenden Endpunkten des Agglomerates. Die durchschnittliche Größe der Agglomerate wurde mit Hilfe von lichtmikroskopischen Aufnahmen der erfindungsgemäßen Agglomerate bestimmt, die eine Auflösung von 1:500 aufwiesen, die dann optisch vermessen wurden. Der Durchschnitt wurde aus 100 Messpunkten ermittelt. Besonders bevorzugt liegt die durchschnittliche Größe der Agglomerate zwischen 0,5 und 40 µm.

Es wurde überraschend gefunden, dass ein hoher Gehalt an mit der organischen Verbindung b) beschichteten Silberoxidpartikeln die Sintereigenschaften sowie die Anbindung an die Oberfläche signifikant verbessern. Daher enthält die Paste in einer bevorzugten Ausführungsform Silberoxid in einer Menge oberhalb von 20 Gew.-%, bevorzugt von 30 bis 95 Gew.-%, insbesondere 60 bis 90 Gew.-%, jeweils bezogen auf das Gesamtgewicht der Paste.

Die Paste enthält eine organische Verbindung b), die sich durch folgende Struktur (I) darstellen lässt:
R¹-COR² (I), wobei R¹ ein aliphatischer Rest mit 8 bis 32 Kohlenstoffatomen ist und R² entweder-OM ist oder die Struktur-X-R³ aufweist, wobei X ausgewählt ist aus der Gruppe bestehend aus O, S, N-R⁴, wobei R⁴ ein Wasserstoffatom oder ein aliphatischer Rest ist, und R³ ein Wasserstoffatom oder ein aliphatischer Rest und M ein Kation ist.

In einer Ausführungsform der vorliegenden Erfindung ist R¹ ein aliphatischer Rest mit 8 bis 32, vorzugsweise 10 bis 24, besonders bevorzugt 12 bis 18, Kohlenstoffatomen, der verzweigt oder unverzweigt sein kann und zusätzlich Heteroatome enthalten kann, und R² entweder-OM oder die Struktur-X-R³ aufweist, wobei X ausgewählt ist aus der Gruppe bestehend aus O, S, N-R⁴, wobei R⁴ ein Wasserstoffatom oder ein aliphatischer Rest ist, und R³ ein Wasserstoffatom oder ein aliphatischer Rest ist und M ein Kation ist. Besonders bevorzugt ist X Sauerstoff (O) und insbesondere ist R³ = H.

R³ und/oder R⁴ ist bevorzugt ein aliphatischer Rest mit 1 bis 32, vorzugsweise 10 bis 24 und insbesondere 12 bis 18 Kohlenstoffatomen, wobei der Rest linear oder verzweigt sein kann und gegebenenfalls zusätzlich Heteroatome aufweisen kann.

Bei der organischen Verbindung b) handelt es sich bevorzugt um eine Verbindung, die aus der Gruppe ausgewählt ist, die aus Fettsäuren (X = O und R³ = H), Fettsäuresalzen (M=Kation) und Fettsäureestern besteht.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Gemäß einer bevorzugten Ausführungsform handelt es sich bei der organischen Verbindung um Monofettsäuren, Salze von Monofettsäuren oder Monofettsäureester.

In einer bevorzugten Ausführungsform ist die organische Verbindung b) eine C₈-C₃₀-Fettsäure, bevorzugt eine C₈-C₂₄-Fettsäure, weiter bevorzugt eine C₁₂-C₁₈-Fettsäure oder ein Derivat hiervon.

Als Fettsäuresalze kommen vorzugsweise Salze in Betracht, deren anionische Komponente die deprotonierte Fettsäure darstellt, und deren kationische Komponente M aus der Gruppe ausgewählt ist, die aus Ammoniumionen, Monoalkylammoniumionen, Dialkylammoniumionen, Trialkylammoniumionen, Lithiumionen, Natriumionen, Kaliumionen, Kupferionen und Aluminiumionen besteht.

Bevorzugte Fettsäureester leiten sich von den entsprechenden Fettsäuren ab, wobei Methyl-, Ethyl-, Propyl- oder Butylester bevorzugt sind.

Gemäß einer bevorzugten Ausführungsform ist die organische Verbindung aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Stearinsäure (Octadecansäure), Mischungen davon, sowie den entsprechenden Estern und Salzen sowie Mischungen davon, besteht.

Gemäß einer besonders bevorzugten Ausführungsform ist die organische Verbindung aus der Gruppe ausgewählt, die aus Laurinsäure (Dodecansäure), Stearinsäure (Octadecansäure), Natriumstearat, Kaliumstearat, Aluminiumstearat, Kupferstearat, Natriumpalmitat und Kaliumpalmitat sowie beliebige Mischungen hiervon besteht.

Die organische Verbindung b) ist weiter bevorzugt ausgewählt aus der Gruppe bestehend aus Oktansäure, Stearinsäure, Laurinsäure, Palmitinsäure und beliebige Mischungen hiervon.

Eine besonders bevorzugte Mischung stellt zum Beispiel eine Mischung aus Laurinsäure und Stearinsäure dar. Bevorzugt ist eine Mischung, in der Laurinsäure und Stearinsäure in einem Gewichtsverhältnis von 25 zu 75 vorliegen.

Vorzugsweise sind die Silberoxidpartikel mit der organischen Verbindung b) ganz oder teilweise beschichtet. Es hat sich gezeigt, dass die beschichteten Silberoxidpartikel und/oder Silberpartikel, insbesondere wenn sie mit Fettsäuren beschichtet sind, weniger stark agglomerieren und es somit weitestgehend vermieden werden kann, dass es zu einer Verklumpung der Silberoxidpartikel und der Silberpartikel in einem frühen Stadium während des Sintervorgangs kommt.

Gemäß einer bevorzugten Ausführungsform enthält die Paste 0,3 bis 6,0 Gew.-%, vorzugsweise 0,5 bis 4,0 Gew.-%, besonders bevorzugt 0,8 bis 2,5 Gew.-%, der organischen Verbindung b), jeweils bezogen auf das Gesamtgewicht der Paste.

Die erfindungsgemäße Paste umfasst ein Dispergiermittel c).

Unter Dispergiermittel c) werden erfindungsgemäß Substanzen verstanden, die andere Substanzen auf physikalischem Wege zur Lösung oder Dispersion bringen können.

Erfindungsgemäß kommen als Dispergiermittel c) die üblicherweise für Sinterpasten verwendeten Dispergiermittel in Betracht. Vorzugsweise werden als Dispergiermittel organische Verbindungen verwendet, die wenigstens ein Heteroatom tragen und 6 bis 24 Kohlenstoffatome, mehr bevorzugt 8 bis 20 Kohlenstoffatome, im speziellen 8 bis 14 Kohlenstoffatome, aufweisen.

Diese organischen Verbindungen können verzweigt oder unverzweigt sein. Bei dem Dispergiermittel c) handelt es sich bevorzugt um zyklische Verbindungen, insbesondere um cyclische und ungesättigte Verbindungen.

Ferner können die als Dispergiermittel verwendeten organischen Verbindungen gesättigte, einfach ungesättigte oder mehrfach ungesättigte Verbindungen sein.

Das wenigstens eine Heteroatom, das in den organischen Verbindungen, die als Dispergiermittel dienen können, enthalten ist, ist vorzugsweise aus der Gruppe ausgewählt, die aus Sauerstoffatomen und Stickstoffatomen besteht.

Das wenigstens eine Heteroatom kann Teil von wenigstens einer funktionellen Gruppe sein.

Gemäß einer besonders bevorzugten Ausführungsform handelt es sich bei dem verwendeten Dispergiermittel um einen Alkohol.

Speziell bevorzugt sind monocyclische Monoterpen-Alkohole, wie beispielsweise Terpineol, insbesondere α-Terpineol.

Besonders bevorzugt liegt der Siedepunkt des Dispergiermittels unterhalb der Temperatur, die für die Sinterung der Pasten verwendet wird. Speziell bevorzugt liegt die Siedetemperatur des Dispergiermittels unterhalb von 240 °C, weiter bevorzugt unterhalb von 230 °C, insbesondere unterhalb von 220 °C.

In einer bevorzugten Ausführungsform ist das Dispergiermittel c) ausgewählt aus der Gruppe bestehend aus alpha-Terpineol, beta-Terpineol, gamma-Terpineol, delta-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester, vorzugsweise Dimethylester der Glutar-, Adipin- oder Bernsteinsäure oder Mischungen davon, Glycerin, Diethylenglycol, Triethylenglycol oder Mischungen hiervon.

Gemäß einer bevorzugten Ausführungsform werden als Dispergiermittel vorzugsweise aliphatische Kohlenwasserstoffverbindungen eingesetzt. Dabei können die aliphatischen Kohlenwasserstoffe aus gesättigten Verbindungen, einfach oder mehrfach ungesättigten Verbindungen sowie Mischungen davon bestehen. Vorzugsweise bestehen die aliphatischen_Kohlenwasserstoffverbindungen aus gesättigten Kohlenwasserstoffverbindungen, wobei diese zyklisch oder azyklisch sein können, wie beispielsweise n-Alkane, Isoalkane, Cycloalkane oder Mischungen davon. Die aliphatischen Kohlenwasserstoffverbindungen können beispielsweise durch die Formeln CₙH₂ₙ₊₂, CₙH₂ₙ und CₙH₂ₙ₋₂ dargestellt werden, wobei n eine ganze Zahl zwischen 5 und 32 ist. In einer besonders bevorzugten Ausführungsform sind die aliphatischen Kohlenwasserstoffverbindungen, die als Dispergiermittel eingesetzt werden können, ausgewählt aus der Gruppe bestehend aus Hexadecan, Octadecan, Isohexadecanen, Isooctadecanen, Cyclohexadecanen und Cyclooctadecanen.

Das Dispergiermittel c) ist verschieden von der organischen Verbindung b), insbesondere ist das Dispergiermittel c) keine organische Verbindung, die unter die Definition der organischen Verbindung b) fällt.

Das Dispergiermittel liegt üblicherweise in einer Menge von 6 bis 40 Gew.-%, vorzugsweise, 8 bis 25 Gew.-%, speziell 10 bis 20 Gew.-%, jeweils bezogen auf das Gesamtgewicht der erfindungsgemäßen Paste, vor.

Durch Art und Menge des Dispergiermittels lassen sich die Fließeigenschaften der Sinterpasten einstellen. Sinterpasten werden bevorzugt in Druckverfahren auf die zu versinternden Bauteile aufgetragen.

Es wurde überraschend gefunden, dass sich die erfindungsgemäße Paste besonders gleichmäßig im Druckverfahren aufbringen lässt, wobei eine glatte Oberfläche entsteht. Bei der Verwendung der erfindungsgemäßen Paste lässt sich eine besonders gleichmäßige Schicht erzeugen, die keine Aufwölbungen an den Seiten aufweist, wie es bei der Verwendung von herkömmlichen Sinterpasten üblich ist.

Ebenfalls wurde überraschend gefunden, dass der Zusatz von organischen Polymeren, welche Sauerstoffatome aufweisen, die Sinterfähigkeit weiter steigert.

Daher umfasst die erfindungsgemäße Paste ein Polymer, welches Sauerstoffatome aufweist.

Das Polymer ist ausgewählt aus der Gruppe bestehend aus Methylcellulose, Ethylcellulose, Ethylmethylcellulose, Carboxycellulose, Hydroxypropylcellulose, Hydroxyethylcellulose, Hydroxymethylcellulose oder Mischungen hiervon.

Es wird angenommen, dass Ethylcellulose die Sinterfähigkeit der Paste durch eine optimierte Umwandlung der organischen Verbindung zu Kohlenmonoxid noch weiter verbessert.

Die erfindungsgemäße Paste enthält 0,05 bis 2,0 Gew.-%, weiter bevorzugt 0,1 bis 0,8 Gew.-% und besondere bevorzugt 0,2 bis 0,5 Gew.-% des Sauerstoff enthaltenden Polymers, wobei die Gewichtsangaben jeweils bezogen sind auf das Gesamtgewicht der Paste.

Darüber hinaus können in der erfindungsgemäßen Paste weitere Inhaltsstoffe, wie zum Beispiel übliche Tenside, Entschäumer, Bindemittel oder viskositätssteuernde Mittel, enthalten sein. Bevorzugt können die Pasten Benetzungsmittel enthalten.

Die weiteren Inhaltsstoffe werden üblicherweise in einer Menge bis zu 0,01 Gew.-%, vorzugsweise von 0,001 bis 0,01 Gew.-%, jeweils bezogen auf das Gesamtgewicht der erfindungsgemäßen Paste, zugesetzt.

Bevorzugt weist die erfindungsgemäße Paste im Wesentlichen kein Glas, insbesondere keine Glasfritte auf. Typische Bestandteile einer Glasfritte sind Bleioxid, Bismutoxid, Alkali- und Erdalkalioxid, Telluroxid und dergleichen.

Im Wesentlichen in diesem Zusammenhang bedeutet, dass der Anteil an Glas in der Paste vorzugsweise weniger als 2 Gew.-%, bevorzugt weniger als 1 Gew.-%, speziell weniger als 0,1 Gew.-%, beispielsweise 0 Gew.-%, beträgt, wobei die Gewichtsangaben jeweils auf das Gesamtgewicht der Paste bezogen sind.

Daher ist eine Ausführungsform der erfindungsgemäßen Paste bevorzugt, bei der der Anteil an Glas in der Paste weniger als 2 Gew.-%, bevorzugt weniger als 0,5 Gew.-%, insbesondere 0,0 bis 0,3 Gew.-%, beträgt, jeweils bezogen auf das Gesamtgewicht der Paste.

Ein weiterer Gegenstand der vorliegenden Erfindung ist ein Verfahren zum Verbinden eines Bauteils oder Moduls mit einem Substrat unter Verwendung der erfindungsgemäßen Paste.

Erfindungsgemäß umfasst das Verfahren zum Verbinden eines Bauelements mit einer ersten Oberfläche auf einem Substrat mit wenigsten einer zweiten Oberfläche die folgenden Schritte:
a) Kontaktieren des Bauelements über die erste Oberfläche mit dem Substrat über wenigstens eine zweite Oberfläche mit der erfindungsgemäßen Paste, wobei sich die Paste zwischen der ersten Oberfläche des Bauelements und der zweiten Oberfläche des Substrates befindet, unter Erhalt eines Aufbaus und
b) Erhitzen des Aufbaus.

Vorzugsweise werden Schritt a) und b) so oft wiederholt, bis der gewünschte Aufbau erreicht ist. So können beispielswiese durch sukzessives und/oder synchrones Verbinden mehrerer gleicher oder unterschiedlicher Bauteile Module hergestellt werden.

Erfindungsgemäß wird unter dem Verbinden von wenigstens einem Bauelement auf einem Substrat das Befestigen von einem Bauelement auf der Oberfläche eines Substrates verstanden. In diesem Zusammenhang bedeutet "auf" lediglich, dass eine Oberfläche des ersten Bauelements mit einer Oberfläche des Substrates verbunden ist, wobei es auf die relative Lage der beiden Oberflächen oder der Anordnung, die die zu verbindenden Oberflächen enthält, nicht ankommt.

Ein Bauelement im Rahmen der vorliegenden Erfindung kann sowohl ein einzelnes Teil sein, das nicht weiter zerlegbar ist, als auch mehr als ein Teil umfassen, wobei die Teile vorzugsweise nicht weiter zerlegbar sind. Der Begriff Bauelement im Sinne der Erfindung umfasst außerdem Module, die aus mehreren Teilen, die untereinander verbunden sein können, besteht.

In einer bevorzugten Ausführungsform des erfindungsgemäßen Verfahrens wird das Bauelement über eine seiner Oberflächen mit einer Oberfläche des Substrates in Kontakt gebracht, wobei das Kontaktieren über die erfindungsgemäße Paste erfolgt. Dabei kann sowohl das Substrat als auch das Bauelement mehr als eine Oberfläche aufweisen. Vorzugsweise wird eine Anordnung bereitgestellt, bei der sich zwischen der Oberfläche des Bauelementes und der Oberfläche des Substrates die erfindungsgemäße Paste befindet.

Gemäß dem vorliegenden Verfahren können auch mehrere Bauelemente und Substrate miteinander verbunden werden. Beispielsweise können ein Substrat und zwei Bauelemente, Bauelement 1 und Bauelement 2, so miteinander verbunden werden, dass das Substrat und das Bauelement 1 und das Bauelement 1 und das Bauelement 2 verbunden werden. Dabei befindet sich die erfindungsgemäße Paste vorzugsweise sowohl zwischen dem Substrat und dem Bauelement 1 als auch zwischen Bauelement 1 und Bauelement 2. Erfindungsgemäß vorgesehen ist, dass das Substrat und die einzelnen Bauelemente in einer Sandwichstruktur vorliegen und miteinander verbunden werden.

Unter Sandwichanordnung ist erfindungsgemäß eine Anordnung zu verstehen, bei der sich die Oberflächen zweier Bauelemente oder eines Bauelements und eines Substrats übereinander befinden und im Wesentlichen parallel zueinander angeordnet sind.

Die Anordnung aus wenigstens einem Bauelement, einem Substrat und einer Paste, wobei sich die Paste zwischen einem Bauelement und einem Substrat dieser Anordnung befindet, kann nach einem aus dem Stand der Technik bekannten Verfahren hergestellt werden.

Vorzugsweise wird zunächst wenigstens eine Oberfläche eines Substrates mit der erfindungsgemäßen Paste versehen. Anschließend wird ein Bauelement mit einer seiner Oberflächen auf die Paste, die auf die Oberfläche des Substrates aufgetragen worden ist, aufgesetzt.

Die Auftragung der Paste auf die Oberfläche eines Substrates oder Bauelements kann mittels herkömmlicher Verfahren erfolgen. Vorzugsweise erfolgt die Auftragung der Paste mittels Druckverfahren, so zum Beispiel mittels Siebdruck oder Schablonendruck. Andererseits kann die Auftragung der Paste auch mittels Dispenstechnik, mittels Spraytechnik, mittels Jet-Technik, mittels Pintransfer oder durch Tauchen erfolgen.

Im Anschluss an die Auftragung der Paste wird vorzugsweise die mit der Paste versehene Oberfläche dieses Bauelements oder Substrates mit einer Oberfläche des damit zu verbindenden Bauelements über die Paste in Kontakt gebracht. Somit befindet sich zwischen den zu verbindenden Bauelementen eine Schicht der Paste.

Unter Substrat wird erfindungsgemäß eine Unterlage oder Grundlage verstanden. Auf dieser Unterlage können beispielsweise Bauelemente befestigt werden. Beispielsweise kann ein Substrat im Sinne der Erfindung eine Unterlage sein, auf der Halbleiterchips zur Kontaktierung ihrer Anschlüsse befestigt werden, beispielsweise eine Leiterplatte. Weiterhin kann unter einem Substrat im Rahmen der vorliegenden Erfindung ein Aufbau aus mehreren Bauelementen verstanden werden, der als Unterlage für weitere Bauelemente dient.

In einer bevorzugten Ausführungsform des erfindungsgemäßen Verfahrens enthält wenigstens eine der Oberflächen wenigstens ein Metall, das ausgewählt ist aus der Gruppe bestehend aus Kupfer, Nickel, Gold, Aluminium und Silber.

In einer besonders bevorzugten Ausführungsform ist das Metall der wenigstens einen Oberfläche Silber.

Besonders bevorzugt ist eine Ausführungsform, in der die wenigstens eine Oberfläche wenigstens ein Metall umfasst oder aus diesem besteht, das ausgewählt ist aus der Gruppe bestehend aus Nickel und Aluminium.

In einer bevorzugten Ausführungsform des Verfahrens beträgt der Anteil des wenigstens einen Metalls in dem Volumen, das durch das Produkt der wenigstens einen Oberfläche und einer Tiefe von 1 µm gebildet wird mindestens 50 Gew.-%, vorzugsweise mindestens 90 Gew.-%, insbesondere 100 Gew.-%, beträgt, jeweils bezogen auf das Gesamtgewicht der Metalle in dem Volumen.

In einer weiteren bevorzugten Ausführungsform ist wenigsten eine der Oberflächen, über die die Kontaktierung erfolgt, ganz oder teilweise mit einer kohlenstoffhaltigen Verbindung bedeckt. Besonders bevorzugt ist die kohlenstoffhaltige Verbindung ein Polymer. Dabei kann es sich beispielsweise um kohlenstoffhaltige Verunreinigungen handeln, die sich während früherer Prozessschritte auf der Oberfläche abgelagert haben. Es wurde überraschendend gefunden, dass unter Verwendung der erfindungsgemäßen Paste auch solche Oberflächen mit einem guten Halt verbunden werden können, die diese kohlenstoffhaltigen Verunreinigungen aufweisen. Bei der Verwendung von Pasten gemäß dem Stand der Technik konnte auf solchen Oberflächen keine Anbindung erzielt werden. Die Oberflächen mussten erst von der kohlenstoffhaltigen Verbindung gereinigt werden, bevor sie miteinander verbunden werden konnten. Dieser Reinigungsschritt entfällt bei der Verwendung der erfindungsgemäßen Paste, was nicht nur den Prozessablauf beschleunigt sondern auch einen ökonomischen Vorteil darstellt.

In einer bevorzugten Ausführungsform erfolgt im Anschluss an das Auftragen der Paste auf die Oberfläche ein Trocknungsschritt.

Unter Trocknung wird vorzugsweise eine Verringerung eines Anteils des Dispergiermediums in der Paste verstanden.

Die Trocknung kann einerseits nach der Herstellung der Anordnung, also nach der Kontaktierung der zu verbindenden Bauelemente oder des Bauelements und des Substrates erfolgen. Andererseits kann die Trocknung aber auch unmittelbar nach dem Auftragen der Paste auf wenigstens eine der Oberflächen des Bauelements oder Substrates und vor der Kontaktierung mit dem zu verbindenden Element erfolgen.

Die Trocknungstemperatur liegt vorzugsweise im Bereich von 50 - 160 °C.

Es versteht sich, dass die Trocknungszeit abhängig ist von der jeweiligen Zusammensetzung der Paste und der Größe der zu sinternden Anordnung. Übliche Trocknungszeiten liegen im Bereich von 5 - 45 Minuten.

Vorzugsweise erfolgt die Trocknung in einer Stickstoffatmosphäre. Besonders bevorzugt weist die Stickstoffatmosphäre dabei einen Sauerstoffgehalt auf, der unterhalb von 50 ppm, vorzugsweise unterhalb von 20 ppm, besonders bevorzugt unterhalb von 5 ppm, liegt, wobei sich die ppm-Werte auf Masseteile beziehen.

Gemäß dem erfindungsgemäßen Verfahren wird der unter Schritt a) erhaltene Aufbau erhitzt. Vorzugsweise ist das Erhitzen ein Sintern.

Die erfindungsgemäße Paste ist sinterbar. Unter Sintern wird vorzugsweise das Verbinden von einem oder mehreren Bauelementen und einem Substrat oder das Verbinden von zwei oder mehr Bauelementen durch Erhitzen unter Umgehung der flüssigen Phase verstanden. Das Sintern erfolgt somit als Diffusionsprozess.

Vorzugsweise erfolgt das Sintern nachdem die Oberflächen des Bauelements und des Substrats über die Paste kontaktiert wurden. Nach dem Sintern kann das Bauelement oder das Substrat mit einem weiteren Bauelement verbunden werden. In einer bevorzugten Ausführungsform erfolgt das Sintern nach der Herstellung des fertigen Aufbaus. Es werden vorzugsweise mehr als eine Kontaktstelle gleichzeitig gesintert.

Das Erhitzen des Aufbaus erfolgt vorzugsweise derart, dass eine elektrisch leitendende und wärmeleitende Verbindung zwischen der Oberfläche des Bauelements und der Oberfläche des Substrates sowie zwischen den Oberflächen der Bauelemente entsteht. Weiterhin bevorzugt erfolgt das Erhitzen derart, dass eine mechanisch stabile Verbindung entsteht.

Vorzugsweise erfolgt das Erhitzen bei Temperaturen zwischen 150 °C und 300 °C, vorzugsweise zwischen 200 °C und 250 °C. Es wurde überraschend gefunden, dass durch die Verwendung der erfindungsgemäßen Pasten das Erhitzen bei niedrigeren Temperaturen als im Stand der Technik allgemein erforderlich vorgenommen werden konnte.

Der Prozessdruck liegt dabei vorzugsweise im Bereich von 30 MPa oder weniger und 0 MPa oder mehr, bevorzugt im Bereich von 5 MPa oder mehr und 25 MPa oder weniger.

Unter Prozessdruck im Sinne der vorliegenden Erfindung ist der Druck zu verstehen, der zusätzlich zum Atmosphärendruck auf die Probe ausgeübt wird. Das Erhitzen bei einem Prozessdruck von 0 MPa bedeutet demnach, dass das Erhitzen ohne die Ausübung eines zusätzlichen Drucks erfolgt, also bei Atmosphärendruck.

Das Erhitzen kann jedoch auch ohne jegliche Anwendung von Prozessdruck, also bei einem Prozessdruck von 0 MPa durchgeführt werden. Die Zeit ist abhängig vom Prozessdruck und liegt vorzugsweise im Bereich von 2 bis 60 Minuten.

Das Erhitzen kann in einer Atmosphäre erfolgen, die nicht weiter eingeschränkt ist. Vorzugsweise wird das Erhitzen jedoch in einer Atmosphäre durchgeführt, die Sauerstoff enthält.

Das Erhitzen wird in einer herkömmlichen, geeigneten Vorrichtung durchgeführt, in der sich vorzugsweise die vorstehend beschriebenen Prozessparameter einstellen lassen.

Es wurde überraschend gefunden, dass beim Sintern unter zusätzlichem Druck ein höherer Anteil an Silberoxid in der Paste zu einer besseren Anhaftung führt. In einer bevorzugten Ausführungsform des erfindungsgemäßen Verfahrens weist die Paste daher 60 bis 95 Gew.-% Silberoxidpartikel, die mit der organischen Verbindung b) vorzugsweise beschichtet sind, auf und bei der das Erhitzen, vorzugsweise Sintern, des Aufbau bei einem Prozessdruck von 5 bis 20 MPa, vorzugsweise 7 bis 15 MPa, erfolgt. Die Menge der Silberoxidpartikel bezieht sich dabei auf das Gesamtgewicht der Paste.

Außerdem wurde überraschend gefunden, dass bei Sintervorgängen, die unter Atmosphärendruck, etwa 101325 Pa, erfolgen, der Bindungseffekt durch das Beimischen von Silberpartikel, vor allem solchen, die mit der organischen Verbindung b) beschichtet sind, positiv verstärkt werden kann. Daher ist eine Ausführungsform des erfindungsgemäßen Verfahrens bevorzugt, in der die Paste 10 bis 30 Gew.-% Silberpartikel, die mit der organischen Verbindung b) bevorzugt beschichtet sind, aufweist und bei der das Erhitzen, vorzugsweise Sintern, des Aufbaus bei einem Prozessdruck im Bereich von 0 MPa bis 3 MPa, vorzugsweise im Bereich von 1 MPa bis 2,5 MPa, erfolgt. Die Menge an Silberpartikel bezieht sich auf das Gesamtgewicht der Paste.

Es wurde überraschend gefunden, dass das erfindungsgemäße Verfahren besonders für das Verbinden von Oberflächen geeignet ist, bei dem wenigstens eine Oberfläche ein unedles Metall, vorzugsweise ausgewählt aus der Gruppe bestehend aus Kupfer, Aluminium und Nickel, aufweist. Daher ist eine Ausführungsform des erfindungsgemäßen Verfahrens bevorzugt, bei der wenigsten eine der Kontaktflächen, also entweder die erste Oberfläche und/oder die zweite Oberfläche, ein unedles Metall, insbesondere Kupfer oder Aluminium oder Nickel ist und wobei die erfindungsgemäße Paste ein Gewichtsverhältnis von Silberpartikeln zu Silberoxidpartikeln bis 6:1, vorzugsweise 1:8 bis 4:1 aufweist.

Alternativ bevorzugt ist eine Ausführungsform des erfindungsgemäßen Verfahrens, bei dem die beiden Kontaktflächen, also die erste und die zweite Oberfläche, Edelmetalle, insbesondere Edelmetalle ausgewählt aus der Gruppe bestehend aus Silber, Gold, Palladium und Platin, sind und die erfindungsgemäße Paste ein Gewichtsverhältnis von Silberpartikeln zu Silberoxidpartikeln 1:8 bis 4:1, vorzugsweise 1:4 bis 2:1 aufweist.

In einer speziellen Ausführungsform ist die erste und/oder die zweite Oberfläche eine Silberoberfläche und die erfindungsgemäße Paste weist ein Gewichtsverhältnis von Silberpartikel zu Silberoxidpartikel von 1:7 bis 5:3 auf.

Ein weiterer Gegenstand der vorliegenden Erfindung ist ein Modul umfassend
i) ein elektronisches Bauteil mit einer ersten Oberfläche
ii) ein Substrat mit wenigstens einer zweiten Oberfläche und
iii) eine Paste gemäß der vorliegenden Erfindung, die mit der ersten Oberfläche und der zweiten Oberfläche in direktem Kontakt steht.

In einer bevorzugten Ausführungsform ist die erfindungsgemäße Paste gesintert.

Weiterhin bevorzugt ist eine Ausführungsform, bei der wenigstens eine der Oberflächen ausgewählt ist aus der Gruppe bestehend aus Kupfer, Silber, Gold, Nickel und Aluminium. Besonders bevorzugt ist eine Ausführungsform, bei der wenigstens eine der Oberflächen ausgewählt ist aus der Gruppe bestehend aus Nickel und Aluminium.

Ebenfalls bevorzugt ist eine Ausführungsform, bei der wenigstens eine der Oberflächen ganz oder teilweise mit einer kohlenstoffhaltigen Verbindung bedeckt ist, wobei die kohlenstoffhaltige Verbindung als Bestandteil der Oberfläche anzusehen ist und folglich mit der erfindungsgemäßen Paste in Kontakt tritt. Bei der kohlenstoffhaltigen Verbindung kann es sich beispielsweise um eine Beschichtung der Oberfläche mit beispielsweise einem Polymer handeln. Weiterhin kann die kohlenstoffhaltige Verbindung aus Verunreinigungen, die sich prozessbedingt auf der Oberfläche angelagert haben, resultieren.

Gemäß der vorliegenden Erfindung umfasst das Modul ein Substrat sowie ein oder mehrere Bauteile. Bevorzugt werden als Bauelemente Teile bezeichnet, die in der Hochleistungselektronik verwendet werden. Vorzugsweise umfasst das Modul elektronische und/oder passive Bauelemente.

Bei den Bauelementen kann es sich beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise AluminiumKühlkörper oder Kupfer-Kühlkörper) oder andere passive Bauelemente (zum Beispiel Widerstände, Kondensatoren oder Spulen) handeln. Vorzugsweise kann es sich bei den Bauelementen auch um nichtmetallische Bauelemente handeln.

Die zu verbindenden Bauelementen können gleichartige oder verschiedenartige Bauelemente sein.

Unter bevorzugten Ausführungsformen betrifft die Erfindung die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat, von DCB oder keramischem Substrat mit Kupfer oder Aluminiumkühlkörper, von Leadframe mit Kühlkörper oder von Tantalkondensatoren, vorzugsweise in ungehäustem Zustand, mit Leadframe.

Ebenfalls bevorzugt können mehr als zwei Bauelemente miteinander verbunden werden. Beispielsweise können (i) LED oder Chip mit (ii) Leadframe und (iii) Kühlkörper verbunden werden, wobei sich der Leadframe vorzugsweise zwischen (i) LED oder Chip und (iii) Kühlkörper befindet. Ebenso kann eine Diode mit zwei Kühlkörpern verbunden werden, wobei sich die Diode vorzugsweise zwischen zwei Kühlkörpern befindet.

Ein weiterer Gegenstand der vorliegenden Erfindung ist ein Verfahren zur Herstellung der erfindungsgemäßen Paste, wobei die Silberoxidpartikel und die Silberpartikel mit der organischen Verbindung b) vermischt werden.

Das Vermischen erfolgt bevorzugt derart, dass eine möglichst vollständige Beschichtung der Silberoxidpartikel und der Silberpartikel mit der organischen Verbindung b) erfolgt. Vorzugsweise kann das Vermischen der Silberoxidpartikel und der Silberpartikel mit der organischen Verbindung b) dadurch erfolgen, dass die organische Verbindung b) in Lösungsmitteln aufgeschlämmt wird und in Zerkleinerungsvorrichtungen, insbesondere Perlmühlen, mit den Silberoxidpartikeln und den Silberpartikeln vermahlen wird. Anschließend können in einem weiteren Schritt die beschichteten Silberoxidpartikel und die beschichteten Silberpartikel getrocknet und entstaubt werden.

In einer bevorzugten Ausführungsform erfolgt das Vermischen mittels jet-milling. Dabei werden die Silberoxidpartikel, die Silberpartikel und die organische Verbindung b) mittels Düsen aufeinander geschossen. Durch den Aufprall werden eventuelle Agglomerate aufgebrochen und eine besonders vorteilhafte Beschichtung der Silberoxidpartikel und der Silberpartikel erreicht.

Die Herstellung der erfindungsgemäßen Paste kann in für den Fachmann geläufigen Mischaggregaten und Rührwerken erfolgen. In einer bevorzugten Ausgestaltung des erfindungsgemäßen Herstellungsverfahrens werden die Silberoxidpartikel und die Silberpartikel in einem ersten Schritt mit der organischen Verbindung b) beschichtet.

In einem nachfolgenden Schritt werden die beschichteten Partikel mit einem Dispergiermittel c) vermischt unter Ausbildung einer sinterbaren Paste.

In einer alternativen Ausführungsform können auch die Silberoxidpartikel und die Silberpartikel mit einem Dispergiermittel c) dispergiert werden und anschließend die organische Verbindung b) hinzugefügt werden.

Die vorliegende Erfindung wird anhand der nachfolgenden Beispiele näher erläutert, wobei die Beispiele jedoch nicht als Einschränkung des Erfindungsgedanken zu verstehen sind.

### Beispiele

### Herstellung von Pasten

Zunächst wurden die Pasten gemäß der in Tabelle 1 angegebenen Mengenverhältnisse durch Vermischen der Bestandteile hergestellt.

Die eingesetzten beschichteten Silberoxidpartikel wiesen eine Beschichtungsmenge von 0,8 Gew.-% auf, bezogen auf das Gesamtgewicht der beschichteten Silberoxidpartikel.

Als Beschichtung wurde eine Mischung aus Stearinsäure und Laurinsäure in einem Massenverhältnis von 75 zu 25 (Stearinsäure : Laurinsäure) verwendet.

Es wurden Silberoxidpartikel verwendet, die eine Primärpartikelgröße von 1 µm aufwiesen, bestimmt mittels Rasterelektronenmikroskopie.

Als Dispergiermittel kam α-Terpineol zum Einsatz.

**Tabelle 1:**

| | Beispiel 1 | Beispiel 2 | Vergleich |
|---|---|---|---|
| α-Terpinenol | 15,72 | 20,466 | 17,447 |
| Ethylcellulose N100 | 0,56 | 0,776 | 0,516 |
| Silberoxid beschichtet¹ | 83,72 | - | - |
| Silberoxid beschichtet² | - | 78,758 | - |
| Silberoxid unbeschichtet³ | - | - | 82,037 |
| | | | |
| Summe | 100 | 100 | 100 |

| | | | |
|---|---|---|---|
| ¹ Die Beschichtung erfolgte mittels jet milling. Die Agglomerate der beschichteten Silberoxidpartikel wiesen eine durchschnittliche Größe von 3 µm auf, bestimmt mittels lichtmikroskopischer Verfahren. ² Die Beschichtung der Silberoxidpartikel erfolgte durch Aufschlämmen der Partikel in einer alkoholischen Lösung der oben genannten Fettsäuremischung und anschließendem Trocknen der Partikel. Die Agglomerate der beschichteten Partikel wiesen eine durchschnittliche Größe von 20 µm auf, bestimmt mittels lichtmikroskopischer Verfahren. ³ Die Agglomerate wiesen eine durchschnittliche Größe von 30 µm auf, bestimmt mittels lichtmikroskopischer Verfahren. | | | |

Das Aufbringen der Paste auf die jeweilige Oberfläche erfolgte mittels Schablonendruck. Als Schablone wurde eine Edelstahlschablone verwendet. Der Rakelwinkel betrug 60° und die Druckgeschwindigkeit lag bei 50 mm/s. Als Oberflächen wurden Silber-DCBs und Kupfer-DCBs verwendet.

### Das Sintern erfolgte entweder unter Druck oder druckfrei.

### a) Drucksintern

Das Drucksintern erfolgte durch Auftragen der Paste auf die Oberfläche eines DCB-Substrates. Anschließend wurde die Paste mit einem Bauteil, welches eine Silberoberfläche oder eine Kupferoberfläche aufweist, in Kontakt gebracht und bei 10 MPa bei 230 °C 3 Minuten versintert.

### b) Druckfreies Sintern (ohne zusätzlichen Prozessdruck)

Das druckfreie Sintern erfolgte durch Auftragen der Paste auf die Oberfläche eines DCB-Substrates. Anschließend wurde die Paste mit einem Bauteil, welches eine Silberoberfläche oder eine Kupferoberfläche aufwies, in Kontakt gebracht.

Das druckfreie Sintern erfolgte nach folgendem Aufwärmprofil:
Innerhalb von 30 Minuten wird die Kontaktstelle kontinuierlich auf 165 °C erwärmt und für 20 Minuten bei 165 °C gehalten. Anschließend wird innerhalb von 5 Minuten die Temperatur kontinuierlich auf 230 °C erhöht und 60 Minuten dort gehalten. Dann wird innerhalb von 50 Minuten kontinuierlich auf 30 °C abgekühlt.

Desweiteren wurden Pasten hergestellt, die neben beschichteten Silberoxidpartikeln beschichtete Silberpartikel enthielten. Dabei waren die Silberpartikel analog der Silberoxidpartikel mit einer Mischung aus 75% Stearinsäure und 25% Laurinsäure beschichtet. Wie auch bei den Silberoxidpartikeln betrug die Beschichtungsmenge 0,8 Gew.-% bezogen auf das Gewicht der beschichteten Silberpartikel. Es wurden zwei Sorten von Silberpartikel verwendet, die einen unterschiedlichen D50-Wert aufwiesen. Die einen Partikel wiesen einen D50-Wert von 4 µm auf, während der D50-Wert der anderen Partikel bei 5,4 µm lag, wobei die Bestimmung des D50-Wertes mittels Laserbeugung gemäß DIN ISO 13320 erfolgte. Die Partikel lagen jeweils in Form von Flakes vor. Die Herstellung der Paste erfolgte analog des oben beschriebenen Prozesses. Die Zusammensetzung ist in Tabelle 2 dargestellt. Die Angaben in Tabelle 2 erfolgen als Gewichtsangaben.

**Tabelle 2:**

| | Beispiel 1 | Beispiel 3 | Beispiel 4 | Beispiel 5 | Beispiel 6 | Beispiel 7 | Beispiel 8 | Beispiel 9 | Vgl. Beispiel 10 |
|---|---|---|---|---|---|---|---|---|---|
| Anteil Silberpartikel | 0% | 10% | 20% | 30% | 40% | 50% | 60% | 70% | 76% |
| α-Terpineol | 15,72 | 15,72 | 15,72 | 15,72 | 15,72 | 15,72 | 15,72 | 15,72 | 11,35 |
| Ethylcellulose N100 | 0,56 | 0,56 | 0,56 | 0,56 | 0,56 | 0,56 | 0,56 | 0,56 | 0,35 |
| Silberoxid beschichtet* | 83,72 | 73,72 | 63,72 | 53,72 | 43,72 | 33,72 | 23,72 | 13,72 | 12,3 |
| Silberpartikel^{**} D50 = 4,0 µm | - | 5 | 10 | 15 | 20 | 25 | 30 | 35 | 38 |
| Silberpartikel^{**} D50 = 5,4 µm | - | 5 | 10 | 15 | 20 | 25 | 30 | 35 | 38 |
| | | | | | | | | | |
| Summe | 100 | 100 | 100 | 100 | 100 | 100 | 100 | 100 | 100 |

| | | | | | | | | | |
|---|---|---|---|---|---|---|---|---|---|
| * Die Beschichtung erfolgte mittels jet milling. Die Beschichtungsmenge betrug 0,8 Gew.-% bezogen auf das Gewicht des beschichteten Silberoxids (Beschichtungsmittel: Stearinsäure:Laurinsäure in einem Gewichtsverhältnis von 75:25). ** Die Silberpartikel sind mit einer Beschichtungsmenge von 0,8 Gew.-% einer Mischung aus Stearinsäure und Laurinsäure (Gewichtsverhältnis Stearinsäure zu Laurinsäure 75:25) beschichtet. | | | | | | | | | |

Die Paste wurde auf eine Metalloberfläche aufgetragen und versintert. Als Metalloberflächen wurden Silberoberflächen und Kupferoberflächen verwendet. Nach dem Sintern wurde die Haftung über die Scherfestigkeit bestimmt. Dabei wurden die Bauteile mit einem Schermeissel bei einer Geschwindigkeit von 0,3 mm/s bei 20 °C abgeschert. Die Kraft wurde mittels einer Kraftmessdose aufgenommen (Gerät DAGE 2000, der Firma DAGE, Deutschland).

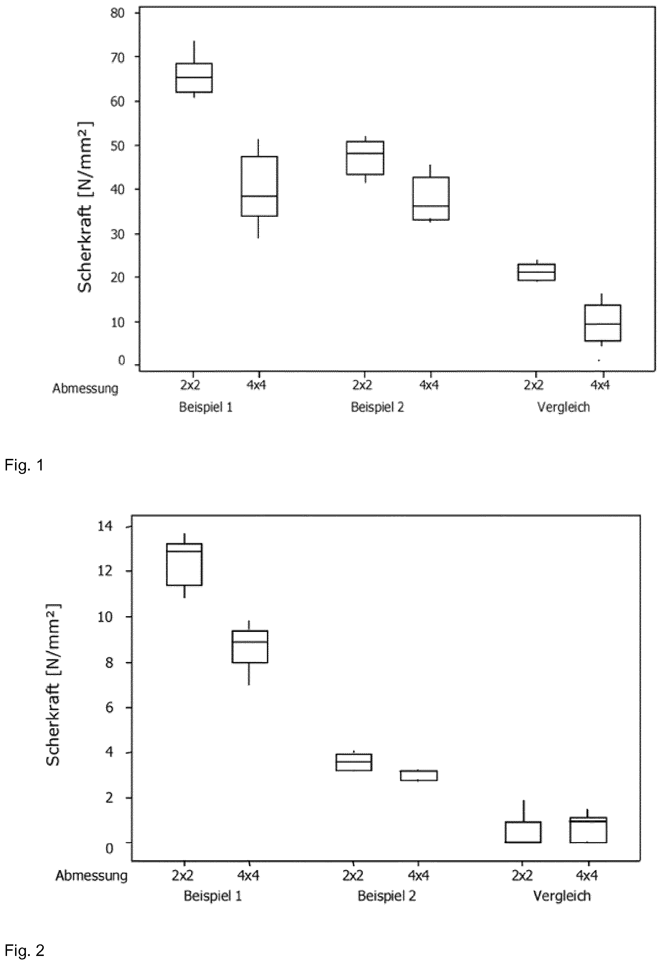

Figur 1 zeigt die Ergebnisse der Schertests, bei denen die in Tabelle 1 angegebenen Pasten vermessen wurden. Das Sintern erfolgte unter Druck gemäß den oben angegebenen Bedingungen. Als Metalloberfläche wurden Silberoberflächen mit Abmessungen von 2x2 mm und 4x4 mm verwendet, die mit Hilfe der Paste auf die Oberfläche eines DCB-Substrates aufgebracht wurden. Wie der Figur zu entnehmen ist, weisen die Proben, bei denen die Silberoxidpartikel mittels jet milling mit der Mischung aus Stearinsäure und Laurinsäure beschichtet wurden, die beste Haftung auf (Beispiel 1). Silberoxidpartikel, deren Beschichtung durch Aufschlämmen der Partikel in einer alkoholischen Lösung der Fettsäuren und anschließendem Trocknen der Partikel erfolgte (Beispiel 2) weisen eine etwas verminderte Haftung auf, die aber immer noch höher als der Vergleich ist, bei dem unbeschichtete Silberoxidpartikel verwendet wurden (Vergleich).
Figur 2 zeigt die Ergebnisse des Schertests der in Tabelle 1 angegebenen Pasten, mit deren Hilfe eine Silberoberfläche der Abmessung 2x2 mm sowie eine Silberoberfläche mit einer Abmessung von 4x4 mm mit der Oberfläche eines DCB-Substrates unter druckfreiem Sintern verbunden wurden. Das druckfreie Sintern erfolgte gemäß dem oben beschriebenen Profil. Auch hier weist die Paste, bei der die Silberoxidpartikel mittels jet milling mit der organischen Verbindung b) beschichtet wurden, die beste Haftung auf (Beispiel 1). Etwas weniger gut, aber immer noch besser als die unbeschichteten Silberoxidpartikel, sind diejenigen, die nicht mittels jet milling beschichtet wurden (Beispiel 2).

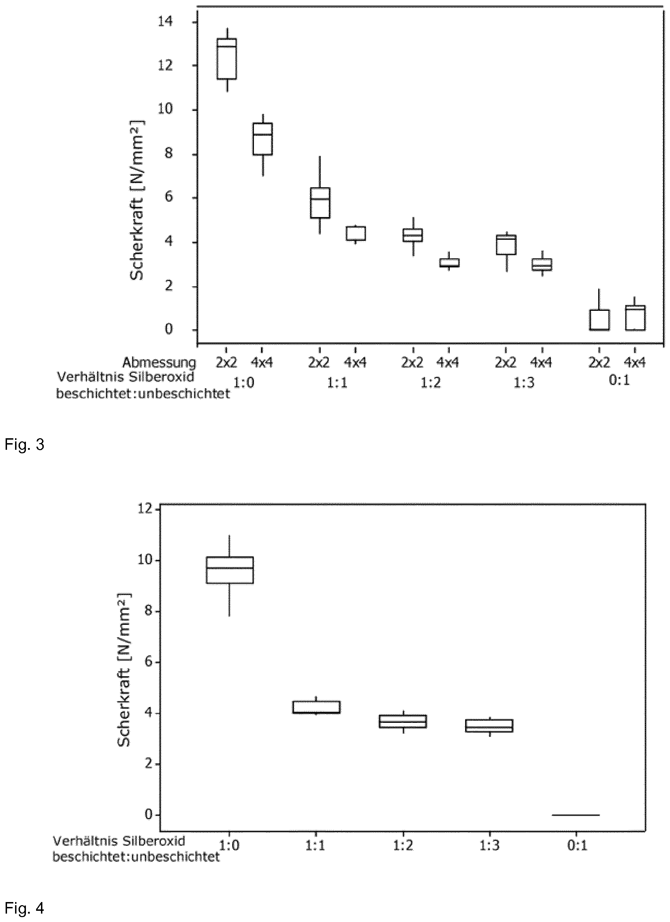

Figur 3 gibt die Ergebnisse der Schertests wieder, bei denen der Paste (Beispiel 1) verschiedene Mengen an unbeschichteten Silberoxidpartikeln zugesetzt wurde. Die Angaben der Verhältnisse von beschichteten Silberoxidpartikeln zu unbeschichteten Silberoxidpartikeln erfolgen als Gewichtsverhältnisse. Die Pasten wurden als Verbindung zwischen Silberoberflächen mit Abmessungen von 2x2 mm und 4x4 mm und der Oberfläche eines DCB-Substrates eingesetzt, wobei das Sintern druckfrei erfolgte. Wie der Figur zu entnehmen ist, sinkt die Haftung der Paste mit zunehmendem Anteil an unbeschichteten Silberoxidpartikeln.
In Figur 4 sind die Testergebnisse der Schertests dargestellt, bei denen der Paste (Beispiel 1) eine zunehmende Menge an unbeschichteten Silberoxidpartikel zugemischt wurde. Die Angaben der Verhältnisse von beschichteten Silberoxidpartikeln zu unbeschichteten Silberoxidpartikeln erfolgen als Gewichtsverhältnisse. Die Paste wurde zum Verbinden einer Kupferoberfläche der Abmessung 4x4 mit der Oberfläche eines DCB-Substrates verwendet. Das Sintern erfolgte druckfrei. Es wurde überraschend gefunden, dass sich mit Hilfe der beschichteten Silberoxidpartikel ein sehr guter Bindungseffekt erzielen lässt, obwohl hier die Gefahr einer starken Oxidation der Kupferoberfläche zu erwarten gewesen wäre.

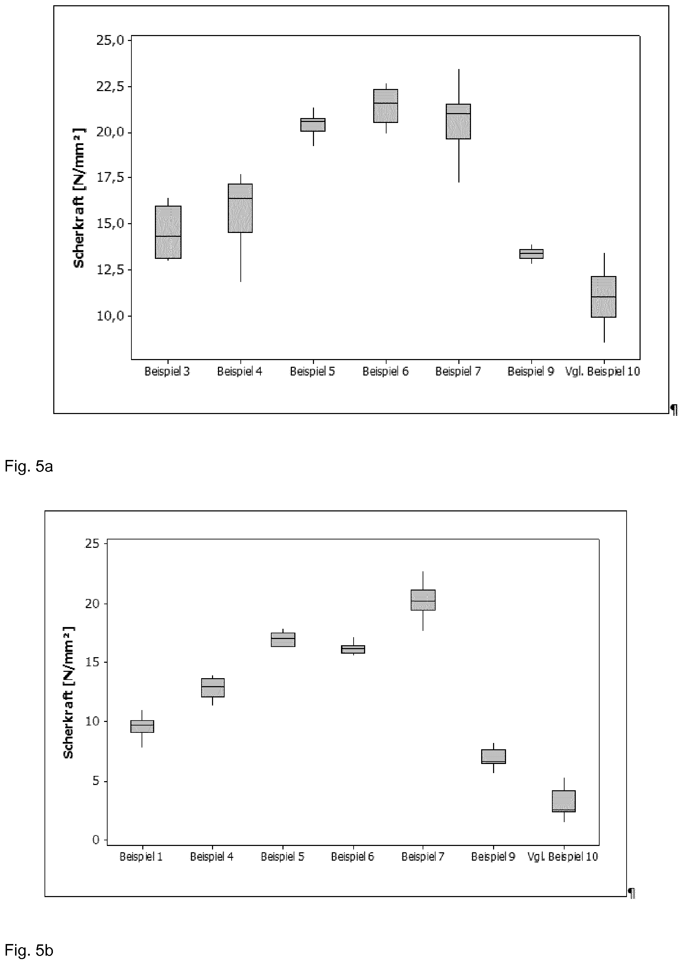

Figur 5a zeigt die Ergebnisse der Schertests der in Tabelle 2 wiedergegebenen Pasten (Beispiele 3 bis 7, Beispiel 9 und Vgl.-Beispiel 10). Dabei wurden Pasten verwendet, die verschiedene Verhältnisse von beschichteten Silberoxidpartikeln zu beschichteten Silberpartikeln aufwiesen. Die Angaben der Verhältnisse von beschichteten Silberoxidpartikeln zu beschichteten Silberpartikeln erfolgen als Gewichtsverhältnisse. Sowohl die Silberoxidpartikel als auch die Silberpartikel sind mit einer Mischung aus Stearinsäure und Laurinsäure in einem Massenverhältnis von 75 zu 25 beschichtet (0,8 Gew.-% bezogen auf beschichtete Partikel). Das Sintern erfolgte druckfrei. Die Pasten wurden als Verbindungen zwischen einer Silberoberfläche der Abmessung 2x2 mm und der Oberfläche eines DCB-Substrates verwendet. Wie der Figur 5a zu entnehmen ist, ist der Bindungseffekt beim druckfreien Sintern am größten, wenn den beschichteten Silberoxidpartikeln bis zu 50 Gew.-% an beschichteten Silberpartikeln zugesetzt werden. Steigt der Anteil der beschichteten Silberpartikel weiter an, nimmt die Haftung wieder ab (Vgl.-Beispiel 10).
Figur 5b zeigt die Ergebnisse der Schertests der in Tabelle 2 angegebenen Pasten (Beispiel 1, Beispiele 4 bis 7, Beispiel 9 und Vgl.-Beispiel 10), wobei die Paste als Verbindung zwischen einer Kupferoberfläche der Abmessungen 2x2 mm und einer DCB-Oberfläche verwendet. Die Angaben der Verhältnisse von beschichteten Silberoxidpartikeln zu beschichteten Silberpartikeln erfolgen als Gewichtsverhältnisse. Sowohl die Silberoxidpartikel als auch die Silberpartikel sind mit einer Mischung aus Stearinsäure und Laurinsäure in einem Massenverhältnis von 75 zu 25 beschichtet (0,8 Gew.-% bezogen auf beschichtete Partikel). Das Sintern erfolgte druckfrei. Wie der Figur zu entnehmen ist, lässt sich durch die Zugabe von beschichteten Silberpartikeln zu der Paste eine Verbesserung der Anhaftung auf einer Kupferoberfläche bei druckfreiem Sintern erzielen. Überschreitet der Anteil an beschichteten Silberpartikeln jedoch einen bestimmten Wert, nimmt die Anbindung wieder ab. Unter Verwendung der in Vergleichsbeispiel 10 angegebenen Paste, bei der der Anteil an beschichteten Silberpartikeln bei 76% der Paste lag, kam es zu keiner zufriedenstellenden Anhaftung.

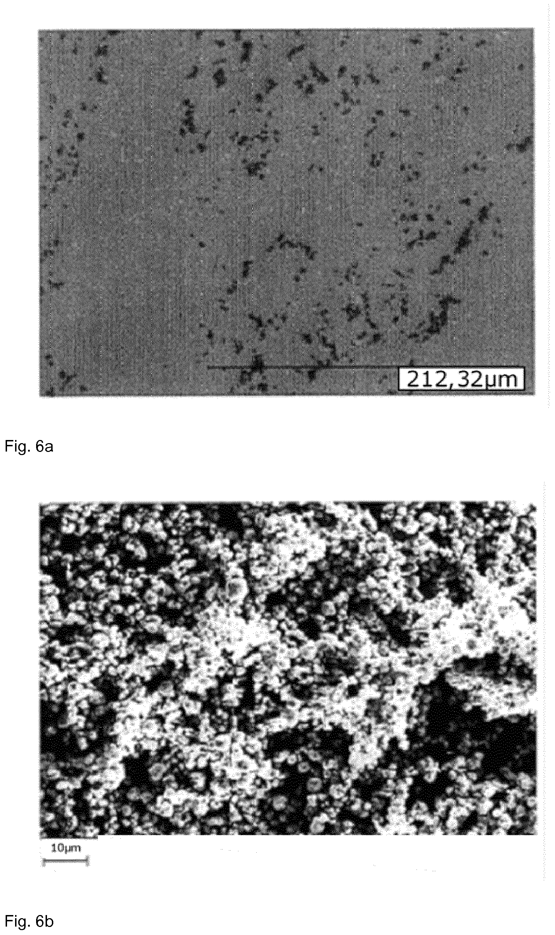

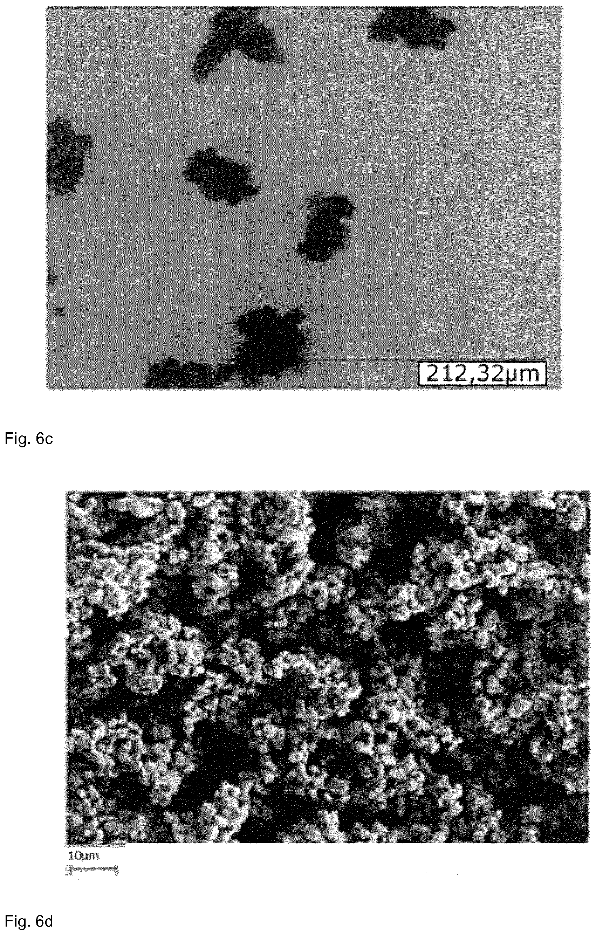

Figur 6 zeigt Aufnahmen einer Oberfläche der mit der organischen Verbindung b) beschichteten Silberoxidpartikel (Figur 6a und 6b) im Vergleich zu nicht beschichteten Silberoxidpartikel (Figur 6c und 6d). Dabei ist deutlich die verminderte Agglomerisationsneigung der mit der Verbindung b) beschichteten Silberoxidpartikel zu erkennen. Die Aufnahmen in den Figuren 6a und 6c wurden mit Hilfe eines Lichtmikroskopes erstellt, die die Aufnahmen in den Figuren 6b und 6d mit einem Rasterelektronenmikroskop aufgenommen. Die Auflösung der lichtmikroskopischen Aufnahmen liegt bei 1:500, die der Rasterelektronenmikroskopaufnahmen bei 1:1000.

## Patentansprüche

1. Paste enthaltend
a) Silberoxidpartikel und Silberpartikel, wobei das Gewichtsverhältnis von Silberpartikel zu Silberoxidpartikel höchstens 6 zu 1 ist,
b) eine organische Verbindung, die durch die Formel I dargestellt ist:
R¹-COR² (I),
wobei R¹ ein aliphatischer Rest mit 8 bis 32 Kohlenstoffatomen ist und R² entweder -OM ist oder die Struktur -X-R³ aufweist, wobei X ausgewählt ist aus der Gruppe bestehend aus O, S, N-R⁴, wobei R⁴ ein Wasserstoffatom oder ein aliphatischer Rest, R³ ein Wasserstoffatom oder ein aliphatischer Rest ist und M ein Kation ist, und
c) ein Dispergiermittel,
**dadurch gekennzeichnet, dass** die Paste, bezogen auf ihr Gesamtgewicht, 0,05 bis 2,0 Gew.-% eines Sauerstoff enthaltenden Polymers enthält, welches ausgewählt ist aus der Gruppe bestehend aus Methylcellulose, Ethylcellulose, Ethylmethylcellulose, Carboxycellulose, Hydroxypropylcellulose, Hydroxyethylcellulose, Hydroxymethylcellulose oder Mischungen hiervon.

2. Paste gemäß Anspruch 1, **dadurch gekennzeichnet, dass** die Silberoxidpartikel ganz oder teilweise mit der organischen Verbindung b) beschichtet sind.

3. Paste gemäß Anspruch 1 oder 2, **dadurch gekennzeichnet, dass** die organische Verbindung b) eine C₈-C₃₀-Fettsäure, bevorzugt eine C₈-C₂₄-Fettsäure, weiter bevorzugt eine C₁₂-C₁₈-Fettsäure oder ein Derivat hiervon ist.

4. Paste gemäß einem der Ansprüche 1 bis 3, **dadurch gekennzeichnet, dass** die durchschnittliche Primärpartikelgröße der mit der organischen Verbindung b) beschichteten Silberoxidpartikel zwischen 0,1 bis 3,0 µm, vorzugsweise 0,3 bis 2,5 µm liegt.

5. Paste gemäß einem der Ansprüche 1 bis 4, **dadurch gekennzeichnet, dass** der Anteil der Silberpartikel kleiner als 30 Gew.-%, vorzugsweise kleiner als 10 Gew.-%, besonders bevorzugt kleiner als 2 Gew.-%, speziell zwischen 0,01 Gew.-% und 2,0 Gew.-%, ist, jeweils bezogen auf das Gesamtgewicht der Paste.

6. Paste gemäß einem der Ansprüche 1 bis 5, **dadurch gekennzeichnet, dass** das Dispergiermittel c) ausgewählt ist aus der Gruppe bestehend aus alpha-Terpineol, beta-Terpineol, gamma-Terpineol, delta-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester, vorzugsweise Dimethylester der Glutar-, Adipin- oder Bernsteinsäure oder Mischungen davon, Glycerin, Diethlenglycol, Triethylenglycol oder Mischungen hiervon.

7. Paste gemäß einem der Ansprüche 1 bis 6, **dadurch gekennzeichnet, dass** die Paste Glas in einem Mengenanteil von weniger als 2 Gew.-%, bevorzugt weniger als 0,5 Gew.-%, insbesondere 0,0 bis 0,3 Gew.-%, jeweils bezogen auf das Gesamtgewicht der Paste, enthält.

8. Paste gemäß einem der Ansprüche 1 bis 7, **dadurch gekennzeichnet, dass** die Paste Silberoxid in einer Menge von 60 bis 95 Gew.-%, bevorzugt 70 bis 90 Gew.-%, aufweist, jeweils bezogen auf das Gesamtgewicht der Paste.

9. Verfahren zum Verbinden eines Bauelementes mit einer ersten Oberfläche auf einem Substrat mit wenigstens einer zweiten Oberfläche, umfassend die Schritte:
a) Kontaktieren des Bauelements über die erste Oberfläche mit dem Substrat über wenigstens eine zweite Oberfläche mit einer Paste gemäß einem der Ansprüche 1 bis 8, wobei sich die Paste zwischen der ersten Oberfläche des Bauelements und der zweiten Oberfläche des Substrats befindet, unter Erhalt eines Aufbaus und
b) Erhitzen des Aufbaus.

10. Verfahren gemäß Anspruch 9, **dadurch gekennzeichnet, dass** wenigstens eine der Oberflächen wenigstens ein Metall enthält, das ausgewählt ist aus der Gruppe bestehend aus Kupfer, Nickel, Gold, Aluminium und Silber.

11. Verfahren gemäß Anspruch 10, **dadurch gekennzeichnet, dass** der Anteil des wenigstens einen Metalls in dem Volumen, das gebildet wird durch das Produkt der wenigstens einen Oberfläche und einer Tiefe von 1 µm mindestens 50 Gew.-%, vorzugsweise mindestens 90 Gew.-%, insbesondere 100 Gew.-%, beträgt, jeweils bezogen auf das Gesamtgewicht der Metalle in dem Volumen.

12. Verfahren gemäß einem der Ansprüche 9 bis 11, **dadurch gekennzeichnet, dass** die wenigstens eine Oberfläche ein oder mehrere Metalle aufweist, ausgewählt aus der Gruppe bestehend aus Nickel und Aluminium.

13. Verfahren gemäß einem der Ansprüche 9 bis 12, **dadurch gekennzeichnet, dass** die wenigstens eine Oberfläche ganz oder teilweise mit einer kohlenstoffhaltigen Verbindung bedeckt ist.

14. Verfahren gemäß Anspruch 13, **dadurch gekennzeichnet, dass** die kohlenstoffhaltige Verbindung ein Polymer ist.

15. Verfahren gemäß einem der Ansprüche 9 bis 14, **dadurch gekennzeichnet, dass** die Paste 60 bis 95 Gew.-% Silberoxidpartikel, die mit der organischen Verbindung b) bevorzugt beschichtet sind, aufweist und bei dem das Erhitzen, vorzugsweise Sintern, des Aufbaus bei einem Prozessdruck von 5 bis 20 MPa, vorzugsweise 7 bis 15 MPa, erfolgt.

16. Verfahren gemäß einem der Ansprüche 9 bis 15, **dadurch gekennzeichnet, dass** die Paste 10 bis 30 Gew.-% Silberpartikel, die mit der organischen Verbindung b) bevorzugt beschichtet sind, aufweist und bei dem das Erhitzen, vorzugsweise Sintern, des Aufbaus bei einem Prozessdruck von 0 bis 3 MPa, vorzugsweise 1 MPa bis 2,5 MPa, erfolgt.

17. Modul umfassend
i) ein elektronisches Bauelement mit einer ersten Oberfläche,
ii) ein Substrat mit wenigstens einer zweiten Oberfläche und
iii) eine Paste gemäß einem der Ansprüche 1 bis 8, die mit der ersten Oberfläche und der zweiten Oberfläche in direktem Kontakt steht.

18. Modul gemäß Anspruch 17, **dadurch gekennzeichnet, dass** die Paste gesintert ist.

19. Modul gemäß einem der Ansprüche 17 und 18, **dadurch gekennzeichnet, dass** wenigstens eine Oberfläche ausgewählt ist aus der Gruppe bestehend aus Kupfer, Silber, Gold, Nickel und Aluminium.

20. Modul gemäß einem der Ansprüche 17 bis 19, **dadurch gekennzeichnet, dass** wenigstens eine Oberfläche ganz oder teilweise mit einer kohlenstoffhaltigen Verbindung bedeckt ist.

## Claims

1. Paste containing
a) silver oxide particles and silver particles, whereby the weight ratio of silver particles to silver oxide particles is at most 6 to 1,
b) an organic compound represented by formula I:
R¹-COR² (I),
whereby R¹ is an aliphatic residue with 8 to 32 carbon atoms and R² is either -OM or comprises the structure -X-R³, whereby X is selected from the group consisting of O, S, N-R⁴, whereby R⁴ is a hydrogen atom or an aliphatic residue, R³ is a hydrogen atom or an aliphatic residue, and M is a cation, and
c) a dispersing agent,
**characterised in that** the paste, relative to its total weight, contains 0.05 to 2.0% by weight of an oxygen-containing polymer selected from the group consisting of methyl cellulose, ethyl cellulose, ethylmethyl cellulose, carboxy cellulose, hydroxypropyl cellulose, hydroxyethyl cellulose, hydroxymethyl cellulose or mixtures thereof.

2. Paste according to claim 1, **characterised in that** the silver oxide particles are fully or partially coated by the organic compound b).

3. Paste according to claim 1 or 2, **characterised in that** the organic compound b) is a C₈-C₃₀-fatty acid, preferably a C8-C24 fatty acid, more preferably a C₁₂-C₁₈-fatty acid or a derivative thereof.

4. Paste according to any one of the claims 1 to 3, **characterised in that** the average primary particle size of the silver oxide particles coated by the organic compound b) is between 0.1 to 3.0 µm, preferably 0.3 to 2.5 µm.

5. Paste according to any one of the claims 1 to 4, **characterised in that** the fraction of the silver particles is less than 30% by weight, preferably less than 10% by weight, particularly preferably less than 2% by weight, specifically between 0.01% by weight and 2.0% by weight, each relative to the total weight of the paste.

6. Paste according to any one of the claims 1 to 5, **characterised in that** the dispersing agent c) is selected from the group consisting of alpha-terpineol, beta-terpineol, gamma-terpineol, delta-terpineol, mixtures of the preceding terpineols, N-methyl-2-pyrrolidone, ethylene glycol, dimethyl acetamide, 1-tridecanol, 2-tridecanol, 3-tridecanol, 4-tridecanol, 5-tridecanol, 6-tridecanol, isotridecanol, dibasic esters, preferably dimethyl esters of glutaric, adipic or succinic acid or mixtures thereof, glycerol, diethylene glycol, triethylene glycol or mixtures thereof.

7. Paste according to any one of the claims 1 to 6, **characterised in that** the paste contains a mass fraction of glass of less than 2% by weight, preferably less than 0.5% by weight, in particular 0.0 to 0.3% by weight, each relative to the total weight of the paste.

8. Paste according to any one of the claims 1 to 7, **characterised in that** the paste contains an amount of silver oxide from 60 to 95% by weight, preferably 70 to 90% by weight, each relative to the total weight of the paste.

9. Process for connecting a component having a first surface on a substrate having at least one second surface, comprising the steps of:
a) contacting the component via the first surface to the substrate via at least one second surface using a paste according to any one of the claims 1 to 8, whereby the paste is situated between the first surface of the component and the second surface of the substrate, while obtaining a construct and
b) heating the construct.

10. Process according to claim 9, **characterised in that** at least one of the surfaces contains at least one metal selected from the group consisting of copper, nickel, gold, aluminium, and silver.

11. Process according to claim 10, **characterised in that** the fraction of the at least one metal in the volume formed by the product of the at least one surface and a depth of 1 µm is at least 50% by weight, preferably at least 90% by weight, in particular 100% by weight, each relative to the total weight of the metals in said volume.

12. Process according to any one of the claims 9 to 11, **characterised in that** the at least one surface comprises one or more metals selected from the group consisting of nickel and aluminium.

13. Process according to any one of the claims 9 to 12, **characterised in that** the at least one surface is fully or partly covered by a carbon-containing compound.

14. Process according to claim 13, **characterised in that** the carbon-containing compound is a polymer.

15. Process according to any one of the claims 9 to 14, **characterised in that** the paste comprises 60 to 95% by weight silver oxide particles that are preferably coated by the organic compound b), and in which the heating, preferably sintering, of the construct takes place at a process pressure from 5 to 20 MPa, preferably 7 to 15 MPa.

16. Process according to any one of the claims 9 to 15, **characterised in that** the paste comprises 10 to 30% by weight silver particles that are preferably coated by the organic compound b), and in which the heating, preferably sintering, of the construct takes place at a process pressure from 0 to 3 MPa, preferably 1 to 2.5 MPa.

17. Module, comprising
i) an electronic component having a first surface,
ii) a substrate having at least one second surface, and
iii) a paste according to any one of the claims 1 to 8 that directly contacts the first surface and the second surface.

18. Module according to claim 17, **characterised in that** the paste is sintered.

19. Module according to any one of the claims 17 and 18, **characterised in that** at least one surface is selected from the group consisting of copper, silver, gold, nickel, and aluminium.

20. Module according to any one of the claims 17 to 19, **characterised in that** at least one surface is fully or partly covered by a carbon-containing compound.

## Revendications

1. Pâte contenant
a) des particules d'oxyde d'argent et des particules d'argent, le rapport pondéral des particules d'argent aux particules d'oxyde d'argent étant d'au plus 6 à 1,
b) un composé organique représenté par la formule I :
R¹-COR² (I),
dans lequel R¹ est un radical aliphatique de 8 à 32 atomes de carbone et R² est soit -OM ou présente la structure -X-R^{3,}, X étant sélectionné parmi le groupe qui se compose de O, S, N-R⁴, dans lequel R⁴ est un atome d'hydrogène ou un radical aliphatique, R³ étant un atome d'hydrogène ou un radical aliphatique et M un cation, et
c) un dispersant,
**caractérisé en ce que** la pâte contient, par rapport à son poids total, 0,05 à 2,0% en poids d'un polymère contenant de l'oxygène sélectionné parmi le groupe qui se compose de la méthylcellulose, l'éthylcellulose, l'éthylméthylcellulose, la carboxycellulose, l'hydroxypropylcellulose, l'hydroxyéthylcellulose, l'hydroxyméthyl-cellulose ou leurs mélanges.

2. Pâte conformément à la revendication n°1, **caractérisée en ce que** les particules d'oxyde d'argent sont totalement ou partiellement revêtues du composé organique b).

3. Pâte conformément à la revendication n°1 ou n°2, **caractérisée en ce que** le composé organique b) est un acide gras en C₈-C₃₀, de préférence un acide gras en C8-C24, mieux encore un acide gras en C₁₂-C₁₈ ou un dérivé de celui-ci.

4. Pâte conformément à l'une des revendications n°1 à n°3, **caractérisée en ce que** la dimension particulaire primaire moyenne des particules d'oxyde d'argent revêtues du composé organique b) est 0,1 à 3,0 µm, de préférence 0,3 à 2,5 µm.

5. Pâte conformément à l'une des revendications n°1 à n°4, **caractérisée en ce que** la proportion des particules d'argent est inférieure à 30% en poids, de préférence inférieure à 10% en poids, mieux encore inférieure à 2% en poids, notamment entre 0,01% en poids et 2,0% en poids, respectivement, par rapport au poids total de la pâte.

6. Pâte conformément à l'une des revendications n°1 à n°5, **caractérisée en ce que** le dispersant c) est sélectionné parmi le groupe qui se compose de l'alpha-terpinéol, le bêta-terpinéol, le gamma-terpinéol, le delta-terpinéol, les mélanges des terpinéols mentionnés précédemment, N-méthyl-2-pyrrolidone, éthylèneglycol, diméthylacétamide, 1-tridécanol, 2-tridécanol, 3-tridécanol, 4-tridécanol, 5-tridécanol, 6-tridécanol, isotridécanol, esters dibasiques, de préférence des esters diméthyliques d'acide glutarique, adipique ou succinique ou leurs mélanges, le glycérol, le diéthylèneglycol, le triéthylèneglycol ou leurs mélanges.

7. Pâte conformément à l'une des revendications n°1 à n°6, **caractérisée en ce que** le pâte contient une proportion de verre inférieure à 2% en poids, de préférence inférieure à 0,5% en poids, en particulier de 0,0 à 0,3% en poids, dans chaque cas par rapport au poids total de la pâte.

8. Pâte conformément à l'une des revendications n°1 à n°7, **caractérisée en ce que** la pâte contient de l'oxyde d'argent en une quantité de 60 à 95% en poids, de préférence de 70 à 90% en poids, dans chaque cas par rapport au poids total de la pâte.

9. Procédé de liaison d'un composant ayant une première surface sur un substrat ayant au moins une seconde surface, comprenant les étapes consistant à :
a) mise en contact du composant par la première surface avec le substrat par au moins une seconde surface avec une pâte conformément à l'une des revendications n°1 à n°8, dans lequel la pâte est située entre la première surface du composant et la seconde surface du substrat, en obtenant une structure et
b) chauffer la structure.

10. Procédé conformément à la revendication n°9, **caractérisé en ce qu'**au moins une des surfaces contient au moins un métal sélectionné parmi le groupe qui se compose du cuivre, du nickel, de l'or, de l'aluminium et de l'argent,

11. Procédé conformément à la revendication n°10, **caractérisé en ce que** la proportion d'au moins un métal dans le volume formé par le produit, d'au moins une surface et une profondeur de 1 µm est d'au moins 50% en poids, de préférence d'au moins 90% en poids, en particulier 100% en poids, dans chaque cas par rapport au poids total des métaux dans le volume.

12. Procédé conformément à l'une des revendications n°9 à n°11, **caractérisé en ce qu'**au moins une surface comprend un ou plusieurs métaux sélectionnés parmi le groupe qui se compose du nickel et de l'aluminium.

13. Procédé conformément à l'une des revendications n°9 à n°12, **caractérisé en ce qu'**au moins une surface est entièrement ou partiellement recouverte d'un composé carboné.

14. Procédé conformément à la revendication n°13, **caractérisé en ce que** le composé carboné est un polymère.

15. Procédé conformément à l'une des revendications n°9 à n°14, **caractérisé en ce que** la pâte comprend de 60 à 95% en poids de particules d'oxyde d'argent, qui sont de préférence revêtues du composé organique b), et dans lequel le chauffage, de préférence le frittage, de la structure s'effectue à une pression de procédé de 5 à 20 MPa, de préférence de 7 à 15 MPa.

16. Procédé conformément à l'une des revendications n°9 à n°15, **caractérisé en ce que** la pâte comprend de 10 à 30% en poids de particules d'argent, qui sont de préférence revêtues du composé organique b), et dans lequel le chauffage, de préférence le frittage, de la structure s'effectue à une pression de procédé de 0 à 3 MPa, de préférence de 1 MPa à 2,5 MPa.

17. Module comprenant
i) un composant électronique avec une première surface,
ii) un substrat avec au moins une seconde surface et
iii) une pâte conformément à l'une des revendications n°1 à n°8 qui est en contact direct avec la première surface et la seconde surface.

18. Module conformément à la revendication n°17, **caractérisé en ce que** la pâte est frittée.

19. Module conformément à l'une des revendications n°17 et n°18, **caractérisé en ce qu'**au moins une surface est sélectionnée parmi le groupe qui se compose du cuivre, de l'argent, de l'or, du nickel et de l'aluminium.

20. Module conformément à l'une des revendications n°17 à n°19, **caractérisé en ce qu'**au moins une surface est entièrement ou partiellement recouverte d'un composé carboné.
